# FASCICULE DE BREVET EUROPEEN

(11) **EP 3 121 607 B1**
(45) Date de publication et mention de la délivrance du brevet: **28.03.2018**
(21) Numéro de dépôt: 16179886.3
(22) Date de dépôt: 18.07.2016
(51) Int. Cl.: G01R 21/133, G01R 19/25, G01R 22/06

(54) **PROCEDE DE MESURE D'UNE CONSOMMATION ENERGETIQUE D'UNE INSTALLATION ELECTRIQUE**
VERFAHREN ZUM MESSEN DES ENERGIEVERBRAUCHS EINER ELEKTRISCHEN ANLAGE
METHOD FOR MEASURING THE ENERGY CONSUMPTION OF AN ELECTRICAL INSTALLATION

(30) Priorité: 21.07.2015 FR 1556899
(43) Date de publication de la demande: 25.01.2017
(73) Titulaire: SAGEMCOM ENERGY & TELECOM SAS, 92500 Rueil-Malmaison (FR)
(72) Inventeur: TEBOULLE, Henri, 92500 RUEIL MALMAISON (FR); NOIRET, Sébastien, 92500 RUEIL MALMAISON (FR); BRETON, Thierry, 92500 RUEIL MALMAISON (FR)
(74) Mandataire: Le Guen-Maillet

(56) Documents cités:
- US-A- 5 815 101
- US-A1- 2008 172 192
- US-A1- 2009 012 728
- US-A1- 2013 082 683
- US-B1- 6 415 244
- US-B1- 7 071 852

## Description

La présente invention concerne des mesures, par un compteur électrique, de consommation énergétique d'une installation électrique que ledit compteur électrique est en charge de superviser. Le document US 2009/012728 A1 divulgue un compteur électrique en charge de mesurer une consommation énergétique d'une installation électrique. Le document divulgue l'utilisation de fréquences d'échantillonnage distinctes afin de réduire les exigences envers l'équipement.

Le document US 5815101 A divulgue l'utilisation de fréquences d'échantillonnage distinctes dans un procédé d'échantillonnage afin de réduire le bruit.

De nombreux appareils génèrent des interférences dans une bande fréquentielle allant de 2 kHz à 150 kHz. En effet, par exemple, le marquage CE (actuellement pour « Conforme aux Exigences »), qui est un marquage réglementaire institué dans le cadre de la législation d'harmonisation technique européenne et octroyant un droit de libre circulation sur l'ensemble du territoire de l'Union Européenne, n'impose pas de régulation dans cette bande fréquentielle. Or, des interférences dans cette bande fréquentielle peuvent perturber des opérations de métrologie effectuées par des compteurs électriques en charge de superviser des consommations énergétiques d'installations électriques que lesdits compteurs électriques sont respectivement en charge de superviser. En considérant par exemple que les opérations de métrologie sont effectuées sur la base d'une fréquence d'échantillonnage à 2600 Hz pour un signal alternatif d'alimentation électrique à 50 Hz, des interférences à une fréquence de 5150 Hz (donc deux fois la fréquence d'échantillonnage moins la fréquence du signal alternatif d'alimentation électrique utilisé pour alimenter lesdites installations électriques) vont perturber lesdites opérations de métrologie. En effet, des interférences à 5150 Hz se replient à 50 Hz au vu de ladite fréquence d'échantillonnage et peuvent donc être comptées comme de l'énergie consommée par lesdites installations électriques lors desdites opérations de métrologie. Les fréquences posant ainsi problème sont celles qui sont décalées de la fréquence du signal alternatif d'alimentation électrique par rapport à un multiple de la fréquence d'échantillonnage. On peut en outre noter que, pour de tels compteurs électriques, les perturbations en dessous de 30 kHz ont un niveau deux fois plus élevé qu'entre 30 kHz et 150 kHz. Cela entraîne des erreurs de comptage pouvant être de l'ordre de 4 à 5%.

Pour être immunes aux interférences dans la bande fréquentielle, un compteur électrique peut être doté de filtres analogiques dans le chemin de courant au sein dudit compteur électrique. Des filtres analogiques de Butterworth peuvent ainsi être employés, mais, comme des harmoniques sont à conserver dans les opérations de métrologie, de tels filtres doivent être au moins d'ordre quatre. Outre leur coût de mise en oeuvre, ces filtres posent le problème du vieillissement de leurs composants analogiques. Leur efficacité au fil du temps s'en trouve dégradée, ce qui provoque une dégradation des précisions des mesures métrologiques à terme.

Il est souhaitable de pallier ces différents inconvénients de l'état de la technique.

Il est notamment souhaitable de fournir une solution qui permette aux compteurs électriques d'effectuer des opérations de métrologie qui ne soient pas perturbées par les interférences susmentionnées, et qui permette de s'abstraire des filtres analogiques susmentionnés. Il est aussi souhaitable de fournir une solution qui soit simple à mettre en oeuvre et à faible coût.

L'invention concerne un procédé de mesure d'une consommation énergétique d'une installation électrique, le procédé étant exécuté par un compteur électrique en charge de superviser ladite installation électrique, chaque mesure de consommation énergétique étant obtenue par échantillonnage d'un signal alternatif d'alimentation électrique alimentant ladite installation électrique. Le procédé est tel qu'il comporte les étapes suivantes : définir des cycles décomposés en au moins trois périodes unitaires de mesure ; sélectionner une fréquence d'échantillonnage pour chaque période unitaire de mesure de telle sorte que des fréquences d'échantillonnage distinctes soient sélectionnées pour les périodes unitaires de mesure de chaque cycle et de telle sorte que la différence entre les fréquences d'échantillonnage de chaque cycle prises deux à deux soit inférieure à la fréquence du signal alternatif d'alimentation électrique ; obtenir une mesure de consommation énergétique pour chaque période unitaire de mesure de chaque cycle, en utilisant la fréquence d'échantillonnage sélectionnée pour ladite période unitaire de mesure ; déterminer les deux mesures de consommation énergétique les plus proches parmi les mesures de consommation énergétique de chaque cycle ; et retenir comme mesure de consommation énergétique, pour chaque cycle, l'une parmi les deux mesures de consommation énergétique les plus proches. Ainsi, de par l'utilisation de ces fréquences d'échantillonnage distinctes par cycle, les opérations de métrologie ne sont pas perturbées par les interférences susmentionnées, ce qui permet de s'abstraire des filtres analogiques susmentionnés.

Selon un mode de réalisation particulier, chaque cycle est décomposé en trois périodes unitaires de mesure.

Selon un mode de réalisation particulier, le compteur électrique applique une séquence de fréquences d'échantillonnage, en changeant de fréquence d'échantillonnage à chaque période unitaire de mesure, ladite séquence étant définie de telle sorte qu'une même fréquence d'échantillonnage ne soit pas utilisée pour plusieurs périodes unitaires de mesure d'un même cycle.

Selon un mode de réalisation particulier, le compteur électrique fournit, à l'issue de chaque cycle via une interface de télé-information client, la mesure de consommation énergétique retenue pour ledit cycle.

Selon un mode de réalisation particulier, chaque mesure de consommation énergétique obtenue est représentative d'une puissance active consommée par ladite installation électrique et/ou d'une puissance réactive consommée par ladite installation électrique et/ou d'un courant consommé par ladite installation électrique et/ou une puissance apparente consommée par ladite installation électrique.

Selon un mode de réalisation particulier, lorsque le compteur électrique est polyphasé, ledit procédé est exécuté pour chaque phase à laquelle ledit compteur électrique est connecté.

L'invention concerne également un compteur électrique en charge de mesurer une consommation énergétique d'une installation électrique que ledit compteur électrique est en charge de superviser, chaque mesure de consommation énergétique étant obtenue par échantillonnage d'un signal alternatif d'alimentation électrique alimentant ladite installation électrique. Ledit compteur électrique est tel qu'il implémente : des moyens pour définir des cycles décomposés en au moins trois périodes unitaires de mesure ; des moyens pour sélectionner une fréquence d'échantillonnage pour chaque période unitaire de mesure de telle sorte que des fréquences d'échantillonnage distinctes soient sélectionnées pour les périodes unitaires de mesure de chaque cycle et de telle sorte que la différence entre les fréquences d'échantillonnage de chaque cycle prises deux à deux soit inférieure à la fréquence du signal alternatif d'alimentation électrique ; des moyens pour obtenir une mesure de consommation énergétique pour chaque période unitaire de mesure de chaque cycle, en utilisant la fréquence d'échantillonnage sélectionnée pour ladite période unitaire de mesure ; des moyens pour déterminer les deux mesures de consommation énergétique les plus proches parmi les mesures de consommation énergétique de chaque cycle ; et des moyens pour retenir comme mesure de consommation énergétique, pour chaque cycle, l'une parmi les deux mesures de consommation énergétique les plus proches.

L'invention concerne également un programme d'ordinateur, qui peut être stocké sur un support et/ou téléchargé d'un réseau de communication, afin d'être lu par un processeur. Ce programme d'ordinateur comprend des instructions pour implémenter le procédé mentionné ci-dessus, lorsque ledit programme est exécuté par le processeur. L'invention concerne également des moyens de stockage comprenant un tel programme d'ordinateur.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
- la Fig. 1 illustre schématiquement un agencement comportant un compteur électrique dans lequel l'invention peut être mise en oeuvre ;
- la Fig. 2 illustre schématiquement un exemple d'architecture matérielle partielle du compteur électrique ;
- la Fig. 3 illustre schématiquement un algorithme, effectué par le compteur électrique, pour retenir une mesure de consommation énergétique parmi un ensemble de mesures successives de consommation énergétique ; et
- la Fig. 4 illustre schématiquement un séquencement de mesures résultant de la présente invention.

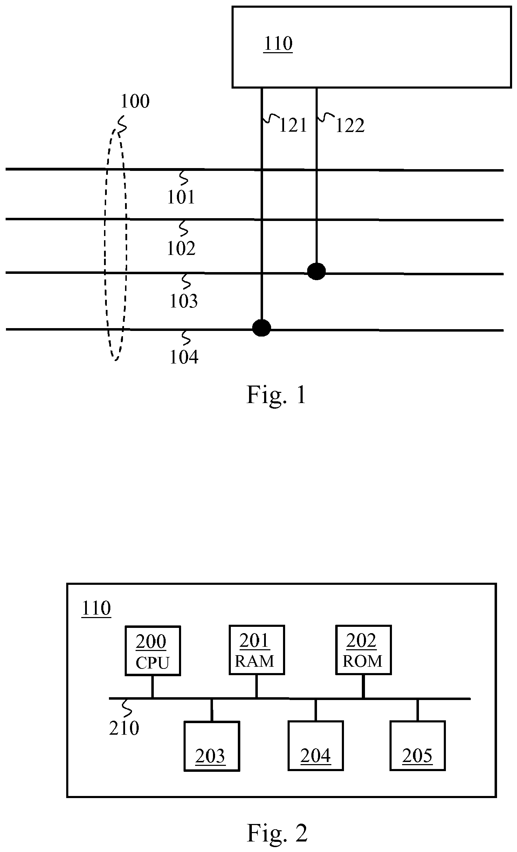

La Fig. 1 illustre schématiquement un agencement comportant un compteur électrique dans lequel l'invention peut être mise en oeuvre.

La Fig. 1 représente un réseau d'alimentation électrique 100 constitué d'une pluralité de fils, un fil étant dédié au neutre et au moins un fil étant dédié à au moins une phase. Dans l'exemple de réalisation représenté par la Fig. 1, le réseau d'alimentation électrique 100 est un système à trois phases, et est donc constitué de quatre fils: un fil de neutre 104, un fil de première phase 101, un fil de seconde phase 102 et un fil de troisième phase 103. Un réseau d'alimentation électrique monophasé pourrait toutefois être utilisé.

La Fig. 1 représente en outre un compteur électrique 110, c'est-à-dire un dispositif servant à effectuer des opérations de comptage de consommation électrique d'une installation électrique que le compteur électrique 110 est en charge de superviser. Le compteur électrique 110 est connecté à un des fils de phase du réseau d'alimentation électrique 100, ainsi qu'au fil de neutre 104, par des liens respectifs 122 et 121. On est, dans ce cas, en présence d'un compteur électrique monophasé. Un compteur électrique polyphasé, e.g. triphasé, pourrait toutefois être utilisé.

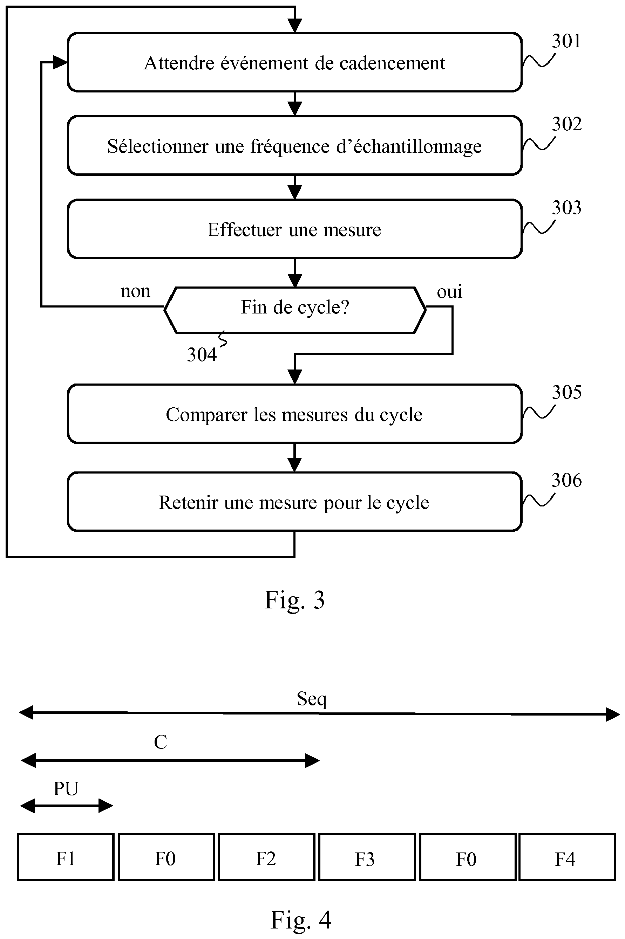

Comme détaillé ci-après en relation avec les Figs. 3 et 4, il est proposé d'effectuer des mesures de consommation énergétique par cycle et de retenir une mesure de consommation énergétique par cycle. Chaque cycle est décomposé en au moins trois périodes unitaires de mesure de même durée prédéfinie (par exemple, une seconde ou deux cents millisecondes), sur lesquelles la consommation énergétique de l'installation électrique supervisée par le compteur électrique 110 est moyennée à partir d'échantillons du signal alternatif d'alimentation électrique. La consommation énergétique de l'installation électrique est représentée par la puissance apparente S et/ou par le courant I et/ou par la puissance réactive P et/ou par la puissance réactive Q. D'une période unitaire de mesure à l'autre dans un même cycle, des fréquences d'échantillonnage différentes sont utilisées pour obtenir lesdits échantillons. En fin de cycle, le compteur électrique 110 fait un choix d'une mesure parmi l'ensemble des mesures résultant des périodes unitaires de mesure dudit cycle. Pour ce faire, le compteur électrique détermine les deux mesures les plus proches parmi les mesures ainsi obtenues, et retient une mesure parmi ces deux mesures les plus proches. Ainsi, grâce à l'emploi de fréquences d'échantillonnage différentes pour les périodes unitaires de mesure d'un même cycle, les mesures effectuées lors d'un même cycle ne sont pas toutes perturbées par une interférence entraînant un repliement (« aliasing » en anglais) à la fréquence du signal alternatif d'alimentation électrique.

La Fig. 2 illustre schématiquement un exemple d'architecture du compteur électrique 110. Le compteur électrique 110 comporte alors, reliés par un bus de communication 210 : un processeur ou CPU (« Central Processing Unit » en anglais) 200 ; une mémoire vive RAM (« Random Access Memory » en anglais) 201 ; une mémoire morte ROM (« Read Only Memory » en anglais) 202 ; une unité de stockage ou un lecteur de support de stockage, tel qu'un lecteur de cartes SD (« Secure Digital » en anglais) 203 ; une interface de télé-information client TIC 204 permettant au compteur électrique 110 de fournir des indications de comptage d'énergie consommée par l'installation électrique supervisée par ledit compteur électrique 110 ; et, optionnellement, une interface 205 permettant au compteur électrique 110 d'effectuer des communications par courants porteurs en ligne (« powerline communications » en anglais) pour notamment fournir, à un concentrateur de données DC (« Data Concentrator » en anglais) dans un cadre de gestion avancée de comptage AMM (« Advanced Metering Management » en anglais), les indications de comptage d'énergie consommée par l'installation électrique supervisée par ledit compteur électrique 110.

Le processeur 200 est capable d'exécuter des instructions chargées dans la RAM 201 à partir de la ROM 202, d'une mémoire externe (non représentée), d'un support de stockage, tel qu'une carte SD, ou d'un réseau de communication. Lorsque le compteur électrique 110 est mis sous tension, le processeur 200 est capable de lire de la RAM 201 des instructions et de les exécuter. Ces instructions forment un programme d'ordinateur causant la mise en oeuvre, par le processeur 200, de tout ou partie de l'algorithme décrit ci-après en relation avec la Fig. 3.

Tout ou partie de l'algorithme décrit ci-après en relation avec la Fig. 3 peut être implémenté sous forme logicielle par exécution d'un ensemble d'instructions par une machine programmable, telle qu'un DSP (« Digital Signal Processor » en anglais) ou un microcontrôleur, ou être implémenté sous forme matérielle par une machine ou un composant dédié, tel qu'un FPGA (« Field-Programmable Gate Array » en anglais) ou un ASIC (« Application-Specific Integrated Circuit » en anglais).

La Fig. 3 illustre schématiquement un algorithme, effectué par le compteur électrique 110, pour retenir une mesure de consommation énergétique parmi un ensemble de mesures successives de consommation énergétique.

Dans une étape 301, le compteur électrique 110 est en attente d'un événement de cadencement des mesures de consommation énergétique. En d'autres termes, le compteur électrique 110 est en attente d'un événement représentatif d'une période unitaire de mesure. Lorsque l'événement survient, le compteur électrique 110 passe à une étape 302.

Dans l'étape 302, le compteur électrique 110 sélectionne une fréquence d'échantillonnage parmi un ensemble prédéfini de fréquences d'échantillonnage. Au sein d'un même cycle, le compteur électrique 110 sélectionne des fréquences d'échantillonnage différentes pour les périodes unitaires de mesure dudit cycle (une fréquence d'échantillonnage par période unitaire de mesure dudit cycle). Les fréquences d'échantillonnage dudit ensemble sont telles que, prises deux à deux, leur différence est inférieure à la fréquence du signal alternatif d'alimentation électrique. La différence minimum entre deux fréquences d'échantillonnage dudit ensemble est telle qu'il existe du glissement entre deux mesures du signal alternatif d'alimentation électrique effectuées avec deux fréquences d'échantillonnage respectives. Par exemple, pour une fréquence de signal alternatif d'alimentation électrique égale à 50 Hz, la différence maximum entre deux fréquences d'échantillonnage dudit ensemble est de 20 Hz et la distance minimum entre deux fréquences d'échantillonnage dudit ensemble est de 5 Hz. Selon un exemple de réalisation, ledit ensemble est constitué des fréquences d'échantillonnage suivantes : 2590 Hz, 2595 Hz, 2600 Hz, 2605 Hz et 2610 Hz.

Dans une étape 303 suivante, le compteur électrique 110 effectue la mesure de consommation énergétique sur la période unitaire de mesure en cours dont le début a été défini par l'événement reçu à l'étape 301. La période unitaire de mesure a une durée prédéfinie (identique d'une période unitaire de mesure à une autre) sur laquelle le compteur électrique 110 obtient, grâce à la fréquence d'échantillonnage sélectionnée à l'étape 302, des échantillons du signal alternatif d'alimentation électrique à partir desquels le compteur électrique 110 obtient ladite mesure de consommation énergétique.

Dans une étape 304 suivante, le compteur électrique 110 vérifie si la période unitaire de mesure sur laquelle la mesure de consommation énergétique a été effectuée à l'étape 303 marque une fin de cycle. Si tel est le cas, une étape 305 est effectuée ; sinon, il reste au moins une période unitaire de mesure avant de terminer le cycle, et l'étape 302 est réitérée.

Dans l'étape 305, le compteur électrique 110 compare les mesures de consommation énergétique effectuées au cours du cycle qui a pris fin. Pour ce faire, le compteur électrique 110 prend lesdites mesures deux à deux et en détermine la différence.

Dans une étape 306 suivante, le compteur électrique 110 retient l'une des deux mesures montrant la différence la plus faible en valeur absolue. Ainsi, une mesure de consommation d'énergie, à savoir de puissance apparente S et/ou de courant I et/ou de puissance active P et/ou de la puissance réactive Q, est disponible à chaque cycle. Le compteur électrique 110 peut rendre disponible, à l'issue de chaque cycle via l'interface de Télé-Information Client (TIC), la mesure de consommation d'énergie retenue pour ledit cycle. En s'appuyant sur des cycles de trois périodes unitaires de mesure de durée égale à une seconde, le compteur électrique 110 est donc apte à fournir la mesure de consommation d'énergie toutes les trois secondes. Ensuite, l'étape 301 est réitérée, dans laquelle le compteur électrique 110 se remet en attente d'une nouvelle période unitaire de mesure marquant un nouveau cycle.

Prenons comme exemple le cas d'une mesure de puissance apparente S. Soit un cycle de trois périodes unitaires de mesure ayant des fréquences d'échantillonnage distinctes, S₁ = 2308 VA est la mesure de puissance apparente S sur la première (en séquence) période unitaire de mesure, S₂ = 1972VA est la mesure de puissance apparente S sur la seconde (en séquence) période unitaire de mesure, et S₃ = 2312 VA est la mesure de puissance apparente S sur la troisième (en séquence) période unitaire de mesure. Le compteur électrique 110 obtient donc une première différence Δ_{1,2} = 336 VA entre S₁ et S₂, une seconde différence Δ_{1,3} = -4 VA entre S₁ et S₃, et une troisième différence Δ_{2,3} = 340 VA entre S₂ et S₃. Ladite seconde différence Δ_{1,3} entre S₁ et S₃ est donc la plus petite différence parmi celles calculées pour le cycle considéré. Le compteur électrique 110 retient alors S₁ ou S₃ comme mesure de puissance apparente S consommée par l'installation électrique pour le cycle considéré. Le principe s'applique pour la puissance active P, la puissance réactive Q et le courant I, consommés par l'installation électrique.

La Fig. 4 illustre schématiquement un séquencement de mesures résultant de la présente invention.

Considérons à titre illustratif que le compteur électrique 110 dispose d'un ensemble de cinq fréquences d'échantillonnage, notées de F0 à F4. Considérons aussi des cycles C de trois périodes unitaires de mesure PU. La Fig. 4 représente ainsi deux cycles successifs de trois périodes unitaires de mesure chacun. Pour la première période unitaire du premier cycle, la fréquence d'échantillonnage F1, par exemple 2605 Hz, est utilisée. Pour la seconde période unitaire du premier cycle, la fréquence d'échantillonnage F0, par exemple 2600 Hz, est utilisée. Pour la troisième période unitaire du premier cycle, la fréquence d'échantillonnage F2, par exemple 2595 Hz, est utilisée. Pour la première période unitaire du second cycle, la fréquence d'échantillonnage F3, par exemple 2590 Hz, est utilisée. Pour la seconde période unitaire du second cycle, la fréquence d'échantillonnage F0 est à nouveau utilisée (à noter que la fréquence d'échantillonnage F0 n'est toutefois utilisée qu'une seule fois dans le second cycle). Et enfin, pour la troisième période unitaire du second cycle, la fréquence d'échantillonnage F4, par exemple 2610 Hz, est utilisée. Le compteur électrique 110 utilise donc une séquence Seq de fréquences d'échantillonnage F1, F0, F2, F3, F0 et F4, que le compteur électrique 110 répète au fil du temps, en changeant de fréquence d'échantillonnage selon ladite séquence en passant d'une période unitaire de mesure à une autre. Ladite séquence Seq de fréquences d'échantillonnage est définie de telle sorte que, en fonction de la quantité de périodes unitaires de mesure par cycle, il est assuré qu'une même fréquence d'échantillonnage ne soit pas utilisée pour plusieurs périodes unitaires de mesure dans un même cycle (la fréquence d'échantillonnage F0 est utilisée deux fois dans ladite séquence Seq de fréquences d'échantillonnage, mais toujours sur des cycles différents).

Il convient de noter que les cycles sont préférentiellement constitués de trois périodes unitaires de mesure, car un tel agencement a l'avantage d'éviter les risques de plusieurs fausses mesures (dues à des interférences) proches.

Il convient aussi de noter que, lorsque le compteur électrique 110 est polyphasé, les principes décrits ci-dessus sont appliqués pour chaque phase à laquelle le compteur électrique 110 est connecté. Les principes décrits ci-dessus peuvent être également appliqués de manière commune sur l'ensemble des phases.

## Revendications

1. Procédé de mesure d'une consommation énergétique d'une installation électrique, le procédé étant exécuté par un compteur électrique (110) en charge de superviser ladite installation électrique, chaque mesure de consommation énergétique étant obtenue par échantillonnage d'un signal alternatif d'alimentation électrique alimentant ladite installation électrique, **caractérisé en ce que** ledit procédé comporte les étapes suivantes :
- définir des cycles décomposés en au moins trois périodes unitaires de mesure ;
- sélectionner (302) une fréquence d'échantillonnage pour chaque période unitaire de mesure de telle sorte que des fréquences d'échantillonnage distinctes soient sélectionnées pour les périodes unitaires de mesure de chaque cycle et de telle sorte que la différence entre les fréquences d'échantillonnage de chaque cycle prises deux à deux soit inférieure à la fréquence du signal alternatif d'alimentation électrique ;
- obtenir (303) une mesure de consommation énergétique pour chaque période unitaire de mesure de chaque cycle, en utilisant la fréquence d'échantillonnage sélectionnée pour ladite période unitaire de mesure ;
- déterminer (305) les deux mesures de consommation énergétique les plus proches parmi les mesures de consommation énergétique de chaque cycle ; et
- retenir (306) comme mesure de consommation énergétique, pour chaque cycle, l'une parmi les deux mesures de consommation énergétique les plus proches.

2. Procédé selon la revendication 1, **caractérisé en ce que** chaque cycle est décomposé en trois périodes unitaires de mesure.

3. Procédé selon l'une quelconque des revendications 1 et 2, **caractérisé en ce que** le compteur électrique applique une séquence (Seq) de fréquences d'échantillonnage, en changeant de fréquence d'échantillonnage à chaque période unitaire de mesure, ladite séquence étant définie de telle sorte qu'une même fréquence d'échantillonnage ne soit pas utilisée pour plusieurs périodes unitaires de mesure d'un même cycle.

4. Procédé selon l'une quelconque des revendications 1 à 3, **caractérisé en ce que** le compteur électrique fournit, à l'issue de chaque cycle via une interface de télé-information client, la mesure de consommation énergétique retenue pour ledit cycle.

5. Procédé selon l'une quelconque des revendications 1 à 4, **caractérisé en ce que** chaque mesure de consommation énergétique obtenue est représentative d'une puissance active consommée par ladite installation électrique et/ou d'une puissance réactive consommée par ladite installation électrique et/ou d'un courant consommé par ladite installation électrique et/ou une puissance apparente consommée par ladite installation électrique.

6. Procédé selon l'une quelconque des revendications 1 à 5, **caractérisé en ce que**, lorsque le compteur électrique est polyphasé, ledit procédé est exécuté pour chaque phase à laquelle ledit compteur électrique est connecté.

7. Programme d'ordinateur, **caractérisé en ce qu'**il comprend des instructions pour mettre en oeuvre, par un compteur électrique, le procédé selon l'une quelconque des revendications 1 à 6, lorsque ledit programme est exécuté par un processeur dudit compteur électrique.

8. Moyens de stockage, **caractérisés en ce qu'**ils stockent un programme d'ordinateur comprenant des instructions pour mettre en oeuvre, par un compteur électrique, le procédé selon l'une quelconque des revendications 1 à 6, lorsque ledit programme est exécuté par un processeur dudit compteur électrique.

9. Compteur électrique (110) en charge de mesurer une consommation énergétique d'une installation électrique que ledit compteur électrique est en charge de superviser, chaque mesure de consommation énergétique étant obtenue par échantillonnage d'un signal alternatif d'alimentation électrique alimentant ladite installation électrique, **caractérisé en ce que** ledit compteur électrique implémente :
- des moyens pour définir des cycles décomposés en au moins trois périodes unitaires de mesure ;
- des moyens pour sélectionner (302) une fréquence d'échantillonnage pour chaque période unitaire de mesure de telle sorte que des fréquences d'échantillonnage distinctes soient sélectionnées pour les périodes unitaires de mesure de chaque cycle et de telle sorte que la différence entre les fréquences d'échantillonnage de chaque cycle prises deux à deux soit inférieure à la fréquence du signal alternatif d'alimentation électrique ;
- des moyens pour obtenir (303) une mesure de consommation énergétique pour chaque période unitaire de mesure de chaque cycle, en utilisant la fréquence d'échantillonnage sélectionnée pour ladite période unitaire de mesure ;
- des moyens pour déterminer (305) les deux mesures de consommation énergétique les plus proches parmi les mesures de consommation énergétique de chaque cycle ; et
- des moyens pour retenir (306) comme mesure de consommation énergétique, pour chaque cycle, l'une parmi les deux mesures de consommation énergétique les plus proches.

## Patentansprüche

1. Verfahren zum Messen eines Energieverbrauchs einer elektrischen Anlage, wobei das Verfahren von einem elektrischen Zähler (110) ausgeführt wird, der die Aufgabe hat, die elektrische Anlage zu überwachen, wobei jede Energieverbrauchsmessung durch Abtasten eines Wechselsignals einer Stromversorgung erhalten wird, die die elektrische Anlage versorgt, **dadurch gekennzeichnet, dass** das Verfahren die folgenden Schritte aufweist:
- Definieren von Zyklen, die in mindestens drei Einzelmessperioden aufgegliedert sind;
- Auswahl (302) einer Abtastfrequenz für jede Einzelmessperiode derart, dass unterschiedliche Abtastfrequenzen für die Einzelmessperioden jedes Zyklus ausgewählt werden, und derart, dass die Differenz zwischen den Abtastfrequenzen jedes Zyklus paarweise genommen niedriger als die Frequenz des Stromversorgungs-Wechselsignals ist;
- Erhalt (303) einer Energieverbrauchsmessung für jede Einzelmessperiode jedes Zyklus unter Verwendung der für die Einzelmessperiode ausgewählten Abtastfrequenz;
- Bestimmen (305) der zwei am nächsten liegenden Energieverbrauchsmessungen unter den Energieverbrauchsmessungen jedes Zyklus; und
- Berücksichtigen (306) als Energieverbrauchsmessung, für jeden Zyklus, einer der zwei am nächsten liegenden Energieverbrauchsmessungen.

2. Verfahren nach Anspruch 1, **dadurch gekennzeichnet, dass** jeder Zyklus in drei Einzelmessperioden aufgegliedert ist.

3. Verfahren nach einem der Ansprüche 1 und 2, **dadurch gekennzeichnet, dass** der elektrische Zähler eine Folge (Seq) von Abtastfrequenzen anwendet, indem er in jeder Einzelmessperiode die Abtastfrequenz ändert, wobei die Folge so definiert wird, dass die gleiche Abtastfrequenz nicht für mehrere Einzelmessperioden eines gleichen Zyklus verwendet wird.

4. Verfahren nach einem der Ansprüche 1 bis 3, **dadurch gekennzeichnet, dass** der elektrische Zähler am Ende jedes Zyklus die Messung des für den Zyklus berücksichtigten Energieverbrauchs über eine Kunden-Ferninformationsschnittstelle liefert.

5. Verfahren nach einem der Ansprüche 1 bis 4, **dadurch gekennzeichnet, dass** jede erhaltene Energieverbrauchsmessung für eine von der elektrischen Anlage verbrauchte Wirkleistung und/oder für eine von der elektrischen Anlage verbrauchte Blindleistung und/oder für einen von der elektrischen Anlage verbrauchten Strom und/oder für eine von der elektrischen Anlage verbrauchte Scheinleistung repräsentativ ist.

6. Verfahren nach einem der Ansprüche 1 bis 5, **dadurch gekennzeichnet, dass**, wenn der elektrische Zähler mehrphasig ist, das Verfahren für jede Phase ausgeführt wird, an die der elektrische Zähler angeschlossen ist.

7. Computerprogramm, **dadurch gekennzeichnet, dass** es Anweisungen enthält, um das Verfahren nach einem der Ansprüche 1 bis 6 durch einen elektrischen Zähler durchzuführen, wenn das Programm von einem Prozessor des elektrischen Zählers ausgeführt wird.

8. Speichereinrichtungen, **dadurch gekennzeichnet, dass** sie ein Computerprogramm speichern, das Anweisungen enthält, um das Verfahren nach einem der Ansprüche 1 bis 6 durch einen elektrischen Zähler durchzuführen, wenn das Programm von einem Prozessor des elektrischen Zählers ausgeführt wird.

9. Elektrischer Zähler (110), der die Aufgabe hat, einen Energieverbrauch einer elektrischen Anlage zu messen, die der elektrische Zähler überwachen soll, wobei jede Energieverbrauchsmessung durch Abtasten eines Wechselsignals einer Stromversorgung erhalten wird, die die elektrische Anlage versorgt, **dadurch gekennzeichnet, dass** der elektrische Zähler implementiert:
- Einrichtungen zur Definition von in mindestens drei Einzelmessperioden aufgegliederten Zyklen;
- Einrichtungen zur Auswahl (302) einer Abtastfrequenz für jede Einzelmessperiode, derart, dass unterschiedliche Abtastfrequenzen für die Einzelmessperioden jedes Zyklus ausgewählt werden, und derart, dass die Differenz zwischen den Abtastfrequenzen jedes Zyklus paarweise genommen niedriger als die Frequenz des Stromversorgungs-Wechselsignals ist;
- Einrichtungen, um eine Energieverbrauchsmessung für jede Einzelmessperiode jedes Zyklus zu erhalten (303), unter Verwendung der ausgewählten Abtastfrequenz für die Einzelmessperiode;
- Einrichtungen, um die zwei am nächsten liegenden Energieverbrauchsmessungen unter den Energieverbrauchsmessungen jedes Zyklus zu bestimmen (305); und
- Einrichtungen, um als Energieverbrauchsmessung für jeden Zyklus eine der zwei am nächsten liegenden Energieverbrauchsmessungen zu wählen (306) .

## Claims

1. Method for measuring an energy consumption of an electrical installation, the method being executed by an electric meter (110) responsible for supervising said electrical installation, each energy consumption measurement being obtained by sampling an AC electrical power supply signal supplying power to said electrical installation, **characterized in that** said method includes the following steps:
- defining cycles broken down into at least three unitary measurement periods;
- selecting (302) a sampling frequency for each unitary measurement period such that separate sampling frequencies are selected for the unitary measurement periods of each cycle and such that the difference between the sampling frequencies of each cycle, taken in pairs, is lower than the frequency of the AC electrical power supply signal;
- obtaining (303) an energy consumption measurement for each unitary measurement period of each cycle, using the sampling frequency selected for said unitary measurement period;
- determining (305) the two closest energy consumption measurements from among the energy consumption measurements of each cycle; and
- retaining (306) one of the two closest energy consumption measurements as an energy consumption measurement for each cycle.

2. Method according to Claim 1, **characterized in that** each cycle is broken down into three unitary measurement periods.

3. Method according to either one of Claims 1 and 2, **characterized in that** the electric meter applies a sequence (Seq) of sampling frequencies, by changing the sampling frequency at each unitary measurement period, said sequence being defined such that one and the same sampling frequency is not used for a plurality of unitary measurement periods of one and the same cycle.

4. Method according to any one of Claims 1 to 3, **characterized in that** the electric meter supplies, at the end of each cycle, via a client remote data interface, the energy consumption measurement retained for said cycle.

5. Method according to any one of Claims 1 to 4, **characterized in that** each energy consumption measurement obtained is representative of an active power consumed by said electrical installation and/or of a reactive power consumed by said electrical installation and/or of a current consumed by said electrical installation and/or an apparent power consumed by said electrical installation.

6. Method according to any one of Claims 1 to 5, **characterized in that**, when the electric meter is polyphase, said method is executed for each phase to which said electric meter is connected.

7. Computer program, **characterized in that** it comprises instructions for an electric meter to implement the method according to any one of Claims 1 to 6 when said program is executed by a processor of said electric meter.

8. Storage means, **characterized in that** they store a computer program comprising instructions for an electric meter to implement the method according to any one of Claims 1 to 6 when said program is executed by a processor of said electric meter.

9. Electric meter (110) responsible for measuring an energy consumption of an electrical installation that said electric meter is responsible for supervising, each energy consumption measurement being obtained by sampling an AC electrical power supply signal supplying power to said electrical installation, **characterized in that** said electric meter implements:
- means for defining cycles broken down into at least three unitary measurement periods;
- means for selecting (302) a sampling frequency for each unitary measurement period such that separate sampling frequencies are selected for the unitary measurement periods of each cycle and such that the difference between the sampling frequencies of each cycle, taken in pairs, is lower than the frequency of the AC electrical power supply signal;
- means for obtaining (303) an energy consumption measurement for each unitary measurement period of each cycle, using the sampling frequency selected for said unitary measurement period;
- means for determining (305) the two closest energy consumption measurements from among the energy consumption measurements of each cycle; and
- means for retaining (306) one of the two closest energy consumption measurements as an energy consumption measurement for each cycle.
